# EUROPEAN PATENT APPLICATION

(11) **EP 4 517 397 A1**
(43) Date of publication of application: **05.03.2025**
(21) Application number: 23796387.1
(22) Date of filing: 25.04.2023
(51) Int. Cl.: G02B 5/30, G02B 1/04, G02B 3/00, G02B 3/08, G02B 5/04, G02F 1/1335, G09F 9/00, H05B 33/02, H05B 33/14, H10K 50/86, H10K 59/10

(54) **OPTICAL RESIN, AND OPTICAL FILM, POLARIZING PLATE, SURFACE PLATE, IMAGE DISPLAY PANEL, IMAGE DISPLAY DEVICE, AND MOLDED PRODUCT FOR OPTICS USING SAID OPTICAL RESIN**

(30) Priority: 26.04.2022 JP 2022072243
(71) Applicant: Dai Nippon Printing Co., Ltd., Tokyo 162-8001 (JP); Koike, Yasuhiro, Kanagawa 225-0012 (JP)
(72) Inventor: HOTTA, Hikaru, Tokyo 162-8001 (JP); KURODA, Takashi, Tokyo 162-8001 (JP); SHINOHARA, Seiji, Tokyo 162-8001 (JP); KOIKE, Yasuhiro, Yokohama-shi, Kanagawa 225-0012 (JP)
(74) Representative: Cabinet Beau de Loménie
(86) International application number: PCT/JP2023/016323
(87) International publication number: WO 2023/210647

(57) **Abstract**

Provided is an optical resin capable of suppressing the occurrence of birefringence due to stress such as internal stress and external stress. An optical resin, in which, regarding a ³C-NMR spectrum of the resin, when a range in which a chemical shift is 141 ppm or higher and 147 ppm or lower is defined as a first range, and a range in which a chemical shift is 135 ppm or higher and 141 ppm or lower is defined as a second range, a ratio of a peak area of a peak in the first range to a peak area of a peak in the second range is 0.55 or less.

## Description

### Technical Field

The present disclosure relates to an optical resin, and an optical film, a polarizing plate, a surface plate, an image display panel, an image display device, and a molded product for optics, for which the optical resin is used.

### Background Art

Image display devices such as liquid crystal display devices and organic EL display devices are in use as display devices in various types of equipment. For example, these display devices are in use in computer display devices; television receivers; car instrument panels; car navigation systems; handheld terminal devices such as smartphones; digital signage; and the like.

In these image display devices, there are cases where optical films are used to improve visibility or suppress scratches on the surfaces. For optical films that are used in image display devices, it is desired to suppress birefringence to improve visibility. Suppression of birefringence is also desired for optical lenses, such as optical pickups, augmented reality lenses (AR lenses), virtual reality lenses (VR lenses), mixed reality lenses (MR lenses), LiDAR lenses, camera lenses, and backlight components in liquid crystal display devices. Therefore, optical resins that are materials of the components of optical films, optical lenses, and backlights and the like are also required to have low birefringence.

In order to suppress the birefringence of resins, the intrinsic birefringence and the photoelectric coefficients are preferably small. As a resin for suppressing birefringence, an optical polymer material of Patent Literature 1 has been proposed.

### Citation List

### Patent Literature

PTL1: JP 2020-126229 A

### Summary of Invention

### Technical Problem

However, there are cases where birefringence occurs in members for which the optical polymer material of Patent Literature 1 is used. For example, in a molded product obtained by the injection molding of the optical polymer material of Patent Literature 1, there was a case where birefringence index occurred due to stress remaining in the molded product. In addition, in an optical film for which the optical polymer material of Patent Literature 1 was used, there was a case where birefringence occurred when load was applied thereto.

An objective of the present disclosure is to provide an optical resin capable of suppressing the occurrence of birefringence due to stress such as internal stress and external stress. In addition, another objective of the present disclosure is to provide an optical film, a polarizing plate, a surface plate, an image display panel, an image display device, and a molded product for optics for which the optical resin is used.

### Solution to Problem

The present disclosure provides the following [1] to [7].
[1] An optical resin, wherein, regarding a ¹³C-NMR spectrum of the optical resin, when a range in which a chemical shift is 141 ppm or higher and 147 ppm or lower is defined as a first range, and a range in which a chemical shift is 135 ppm or higher and 141 ppm or lower is defined as a second range, a ratio of a peak area of a peak in the first range to a peak area of a peak in the second range is 0.55 or less.
[2] An optical film, containing the optical resin according to [1].
[3] A polarizing plate, having a polarizer; a first transparent protection plate arranged on one side of the polarizer; and a second transparent protection plate arranged on another side of the polarizer,
   wherein at least one selected from the group consisting of the first transparent protection plate and the second transparent protection plate includes the optical film according to [2].
[4] A surface plate for an image display device, having a protective film pasted onto a resin plate or a glass plate, wherein the protective film includes the optical film according to [2].
[5] An image display panel, having the optical film according to [2] on a display element.
[6] An image display device, including the image display panel according to [5].
[7] A molded product for optics, containing the optical resin according to [1].

### Advantageous Effects of Invention

The optical resin of the present disclosure, and the optical film, the polarizing plate, the surface plate, the image display panel, the image display device, and the molded product for optics for which the optical resin is used, are capable of suppressing the occurrence of birefringence due to stress.

### Brief Description of Drawing

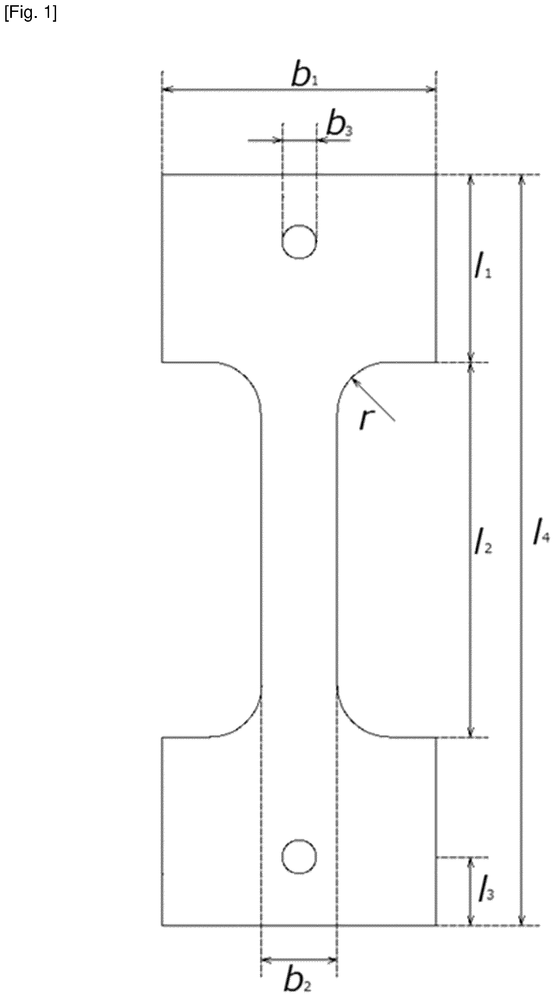

[Fig. 1] Fig. 1 is a plan view for describing a sample for measuring the photoelastic coefficient.

### Description of Embodiments

Hereinafter, an optical resin of the present disclosure, and an optical film, a polarizing plate, a surface plate, an image display panel, an image display device, and a molded product for optics, for which the optical resin is used, will be described.

### [Optical resin]

In the optical resin of the present disclosure, regarding a ¹³C-NMR spectrum of the optical resin, when a range in which a chemical shift is 141 ppm or higher and 147 ppm or lower is defined as a first range, and a range in which a chemical shift is 135 ppm or higher and 141 ppm or lower is defined as a second range, the ratio of the peak area of a peak in the first range to the peak area of a peak in the second range is 0.55 or less.

Regarding the ¹³C-NMR spectrum, the peak in the first range in which the chemical shift is 141 ppm or higher and 147 ppm or lower is a peak that is generated when styrene-based monomers have been polymerized and is attributed to benzene rings of the styrene-based monomers. On the other hand, regarding the ¹³C-NMR spectrum, the peak in the second range in which the chemical shift is 135 ppm or higher and 141 ppm or lower is a peak that is generated when a maleimide-based monomer and a styrene-based monomer have been alternatively copolymerized and is attributed to a benzene ring of the styrene-based monomer.

Therefore, "the ratio of the peak area of the peak in the first range to the peak area of the peak in the second range" indicates "the ratio of a homocopolymer of the styrene-based monomers in the optical resin to an alternative copolymer of the maleimide-based monomer and the styrene-based monomer in the optical resin."

That is, the ratio of the peak area of the peak in the first range to the peak area of the peak in the second range being 0.55 or less means that, in the optical resin, the ratio of the homocopolymer of the styrene-based monomers to the alternative copolymer of the maleimide-based monomer and the styrene-based monomer is small.

In the present specification, "the ratio of the peak area of the peak in the first range to the peak area of the peak in the second range" will be referred to as "peak area ratio" in some cases.

The optical resin of the present disclosure has at least the peak area of the peak in the second range. The optical resin of the present disclosure may or may not have the peak area of the peak in the first range. Specific examples of the peak area will be shown in the following (1) to (4). The following (1) and (2) are optical resins corresponding to Examples, and the following (3) and (4) are optical resins corresponding to Comparative Examples.
(1) In the present specification, for an optical resin in which the peak area of the peak in the second range is 100 and the peak area of the peak in the first range is zero, the peak area ratio is zero.
(2) In the present specification, for an optical resin in which the peak area of the peak in the second range is 100 and the peak area of the peak in the first range is 50, the peak area ratio is 0.50.
(3) In the present specification, for an optical resin in which the peak area of the peak in the second range is zero and the peak area of the peak in the first range is 100, the peak area ratio is infinite (expressed as "∞" in the Comparative Examples).
(4) In the present specification, for an optical resin in which the peak area of the peak in the second range is zero and the peak area of the peak in the first range is zero, the peak area ratio is undeterminable (expressed as "-" in the Comparative Examples).

The alternative copolymer of the maleimide-based monomer and the styrene-based monomer is capable of suppressing the occurrence of birefringence due to stress by suppressing conformation, which is the motion of molecules relative to each other, together.

However, even when the optical resin contains the alternative copolymer of the maleimide-based monomer and the styrene-based monomer, if the ratio of the homocopolymer of the styrene-based monomers increases and the peak area ratio exceeds 0.55, it is not possible to suppress birefringence caused by stress.

In addition, homopolymers of maleimide-based monomers and homopolymers of styrene-based monomers each exhibit a positive value in terms of the photoelastic birefringence. Therefore, resins obtained by blending a homopolymer of a styrene-based monomer and a homopolymer of a maleimide-based monomer are not capable of suppressing birefringence caused by stress. The resins obtained by blending a homopolymer of a styrene-based monomer and a homopolymer of a maleimide-based monomer are not suitable for optical uses since it is not possible to decrease the haze.

The optical resin of the present disclosure has a peak area ratio of 0.55 or less and is thus capable of suppressing the occurrence of birefringence due to stress. The peak area ratio of the optical resin is preferably 0.40 or less, more preferably 0.25 or less, and more preferably 0.15 or less. The peak area ratio of the optical resin may be zero. The peak area ratio of the optical resin being zero means that the optical resin contains the alternative copolymer of the maleimide-based monomer and the styrene-based monomer, but does not contain the homopolymer of the styrene-based monomers.

When the peak area ratio of the optical resin is made to be 0.55 or less, it is also possible to facilitate a decrease in the haze of the optical resin. When the peak area ratio of the optical resin is made to be 0.55 or less, it is also possible to facilitate improvement in scratch resistance, such as pencil hardness and steel wool resistance.

Examples of a situation where stress is applied to the optical resin or internal stress remains in the optical resin include the following (1) to (3).
(1) In a molded product made of the optical resin, stress is likely to remain in the resin. Particularly, in injection molding and extrusion molding, the optical resin is rapidly cooled from a high-temperature state, and internal stress is thus likely to remain.
(2) In a case where heat is transferred to an article made of the optical resin, stress is likely to be applied to the resin when the article has thermally expanded.
(3) When an article made of the optical resin is incorporated into equipment, such as a liquid crystal display device, by fixation, adhesion, or the like, stress is likely to be applied to the resin.

In the present specification, the ¹³C-NMR spectrum can be measured by, for example, a method described in Examples.

The optical resin preferably contains the alternative copolymer of the maleimide-based monomer and the styrene-based monomer.

### <Maleimide-based monomer>

Examples of the maleimide-based monomer include maleimides (unsubstituted maleimides), N-substituted maleimides, and maleimide derivatives other than N-substituted maleimides.

The N-substituted maleimides are maleimides in which a hydrogen atom bonded to a nitrogen atom of maleimides has been substituted with a substituent. The substituent is preferably a substituent having 1 or more and 6 or less carbon atoms, more preferably a hydrocarbon group having 1 or more and 6 or less carbon atoms, and still more preferably an alkyl group having 1 or more and 6 or less carbon atoms.

The hydrocarbon group and the alkyl group may have a substituent.

The alkyl group may be linear or may have a branch.

When having a cycloalkyl group as the substituent, the optical resin is likely to be broken during the molding of the optical resin. Therefore, the substituent is preferably an alkyl group having 1 or more and 6 or less carbon atoms.

The maleimide-based monomer can be represented by, for example, the following general formula (I).

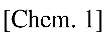

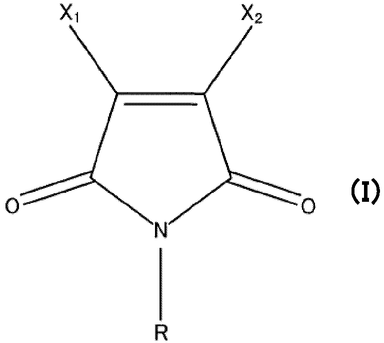

Examples of "R" in the formula (I) include hydrogen; and alkyl groups optionally having a substituent such as a methyl group, an ethyl group, a propyl group, an isopropyl group, a butyl group, a 1-methylpropyl group, a 2-methylpropyl group, a pentyl group, a 1,1-dimethylpropyl group, a 1,2-dimethylpropyl group, a 2,2-dimethylpropyl group, a 1-ethylpropyl group, a 2-ethylpropyl group, a 1-methylbutyl group, a 2-methylbutyl group, a 3-methylbutyl group, a hexyl group, a 1-methylpentyl group, a 2-methylpentyl group, a 3-methylpentyl group, a 4-methylpentyl group, a 1-ethylbutyl group, a 2-ethylbutyl group, a 1,1-dimethylbutyl group, a 1,2-dimethylbutyl group, a 1,3-dimethylbutyl group, a 2,2-dimethylbutyl group, a 2,3-dimethylbutyl group, a 1,1,2-trimethylpropyl group, a 1,2,2-trimethylpropyl group, a 1-methyl-1-ethylpropyl group, a 1-ethyl-2-methylpropyl group, a 1,1-diethylethyl group, a 2-ethylhexyl group, a chloromethyl group, a dichloromethyl group, a trichloromethyl group, a fluoromethyl group, a difluoromethyl group, a trifluoromethyl group, a chlorofluoromethyl group, a dichlorofluoromethyl group, a bromomethyl group, an iodomethyl group, a 1-chloroethyl group, a 2-chloroethyl group, a 2,2,2-trichloroethyl group, a 1,1,2,2,2-pentachloroethyl group, a 1-fluoroethyl group, a 2-fluoroethyl group, a 2,2,2-trifluoromethyl group, a 1,1,2,2,2-pentafluoroethyl group, a 2-bromoethyl group, and a 2,2,2-tribromoethyl group.

In the formula (I), "R" is preferably an alkyl group having 1 or more and 6 or less carbon atoms, more preferably an alkyl group having no substituent having 1 or more and 6 or less carbon atoms, and still more preferably an alkyl group having no substituent having 3 or more and 5 or less carbon atoms. The reason for the alkyl group having no substituent being preferable is that a halogen as the substituent has a high load on the environment and a hydroxy group as the substituent is likely to increase the viscosity by absorbing moisture or the like, which makes molding workability deteriorate. The reason for the alkyl group having 1 or more and 6 or less carbon atoms being preferable is that "as the number of carbon atoms increases, the glass transition temperature of the optical resin decreases, which makes it possible to further facilitate the molding temperature to decrease" and "having 6 or less carbon atoms makes it possible to suppress an increase in the viscosity during molding." As the alkyl group having 1 or more and 6 or less carbon atoms, a tert-butyl group is not preferable since the tert-butyl group is easily decomposed by heat.

Based on what has been described above, "R" in the formula (I) is preferably a propyl group, an isopropyl group, a butyl group, an isobutyl group, a sec-butyl group, a pentyl group, an isopentyl group, a sec-pentyl group, or a tert-pentyl group.

Examples of "X₁" and "X₂" in the formula (I) include hydrogen, fluorine, chlorine, bromine, iodine, a methyl group, and the like. "X₁" and "X₂" may be the same as or different from each other. In the formula (I), "X₁" and "X₂" are preferably hydrogen. In a case where "X₁" and "X₂" are halogens, the load on the environment becomes high, which is not preferable.

As the maleimide-based monomer, one or more selected from the group consisting of a maleimide and a N-substituted maleimide substituted with a hydrocarbon group having 1 or more and 6 or less carbon atoms are preferably contained.

### <Styrene-based monomer>

Examples of the styrene-based monomer include styrene and styrene derivatives.

The styrene-based monomer can be represented by, for example, the following general formula (II).

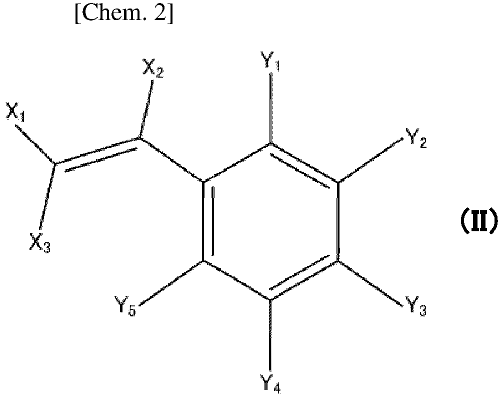

Examples of "X₁", "X₂", and "X₃" in the formula (II) include hydrogen, fluorine, chlorine, bromine, iodine, a hydroxy group, a methyl group, and the like. "X₁", "X₂", and "X₃" may be the same as or different from one another.

A halogen as the substituent has a high load on the environment, and a hydroxy group as the substituent is likely to increase the viscosity by absorbing moisture or the like, which makes molding workability deteriorate. Therefore, "X₁", "X₂", and "X₃" in the formula (II) are preferably hydrogen or methyl groups and more preferably hydrogen.

Examples of "Y₁" to "Y₅" in the formula (II) include hydrogen, fluorine, chlorine, bromine, iodine, a hydroxy group, a methyl group, a hydroxymethyl group, an ethyl group, a propyl group, an isopropyl group, a butyl group, a tert-butyl group, a pentyl group, a hexyl group, and the like. "Y₁" to "Y₅" may be the same as or different from one another.

A halogen as the substituent has a high load on the environment, and a hydroxy group as the substituent is likely to increase the viscosity by absorbing moisture or the like, which makes molding workability deteriorate. In addition, in a case where "Y₁" to "Y₅" are alkyl groups having 2 or more carbon atoms, the fluidity of the optical resin deteriorates when having been melted. Therefore, in the formula (II), "Y₁" to "Y₅" are preferably hydrogen or methyl groups and more preferably hydrogen.

As the styrene-based monomer, one or more selected from the group consisting of styrene, α-methylstyrene, o-methylstyrene, m-methylstyrene, and p-methylstyrene are preferably contained. Among the styrene-based monomers, styrene is capable of facilitating the temperature during molding to be decreased while suppressing embrittlement since it is easy to adjust the glass transition temperature of styrene, which is preferable.

### «Biomass-derived component»

At least one or more monomers selected from the group consisting of the maleimide-based monomer and the styrene-based monomer preferably contain a biomass-derived component. The use of the monomer containing a biomass-derived component makes it possible to increase the biomass degree of the optical resin. A suitable embodiment of the optical resin of the present disclosure is capable of suppressing the occurrence of birefringence due to stress regardless of the high biomass degree of the optical resin and is thus useful.

Examples of the monomer containing a biomass-derived component include, primarily, maleimide-based monomers obtained by reacting a biomass-derived maleic anhydride and a primary amine.

The biomass-derived maleic anhydride can be obtained by, for example, "a step 1 of obtaining a mixture of fumaric acid and maleic acid from furfural" and "a step 2 of dehydrating the maleic acid obtained in the step 1 to obtain a maleic anhydride." The furfural can be obtained from, for example, agricultural by-products such as corncobs, rice husks, sugarcane bagasse, cotton husks, oat husks, almond shells, and olive press cake. A method for obtaining furfural from agricultural by-products has been reported in, for example, "Authors: Yuya Tachibana, Senri Hayashi, Ken-Ichi Kasuya; Development of biobased Materials Derived from Furfural; Journal of The adhesion Society of Japan Vol. 53 No. 8 2017."

The maleimide-based monomers obtained by reacting a biomass-derived maleic anhydride and a primary amine are preferable since the optical characteristics, such as the refractive index, are easily adjusted by changing the kind of the primary amine.

Examples of the primary amine include methylamine, ethylamine, propylamine, isopropylamine, butylamine, isobutylamine, sec-butylamine, pentylamine, isopentylamine, sec-pentylamine, tert-pentylamine, and the like. Among these, propylamine, isopropylamine, butylamine, isobutylamine, sec-butylamine, pentylamine, isopentylamine, sec-pentylamine, and tert-pentylamine are preferable.

Examples of the monomer containing a biomass-derived component include, secondly, styrene monomers obtained by reacting a biomass-derived ethylene and a biomass-derived benzene. For α-methylstyrene, o-methylstyrene, m-methylstyrene, and p-styrene, the amount of carbon dioxide discharged is likely to increase due to an increase in the number of steps for producing the monomer. Therefore, the styrene monomer is preferably styrene itself.

The biomass-derived ethylene and the biomass-derived benzene can be obtained by, for example, "a step 1 of decomposing lignocellulose into a water-soluble compound group having approximately 2 to 6 carbon atoms" and "a step 2 of converting the water-soluble compound group obtained in the step 1 into olefin-based hydrocarbons, such as ethylene, propylene, and butylene, and aromatic hydrocarbons, such as benzene, toluene, and xylene, using a solid acid catalyst." These steps have been reported in, for example, the homepage of Nippon Shokubai Co., Ltd. (https://www.shokubai.co.jp/ja/news/news0275.html).

As an example of the alternative copolymer of the maleimide-based monomer and the styrene-based monomer, the structural formula of an alternative copolymer of maleimide and styrene will be shown below. In a polymerization reaction between the maleimide-based monomer and the styrene-based monomer, an alternative copolymer is easily formed since the monomer reactivity ratios r1 and r2 are extremely small.

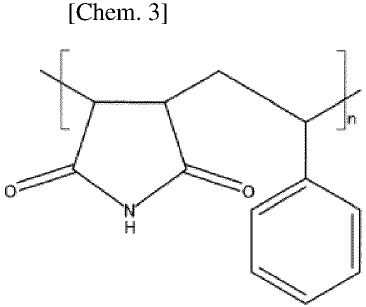

The optical resin of the present disclosure can be obtained by, for example, polymerizing the maleimide-based monomer and the styrene-based monomer.

As described above, in the polymerization reaction between the maleimide-based monomer and the styrene-based monomer, an alternative copolymer is easily formed since the monomer reactivity ratios r1 and r2 are extremely small. Therefore, in a binary system, the mole ratio between the maleimide-based monomer and the styrene-based monomer is likely to become approximately 50:50 in the optical resin. In a case where the ratio of the maleimide-based monomer is increased in the optical resin, the ratio of the maleimide-based monomer to the styrene-based monomer needs to be sufficiently increased as a raw material monomer. In addition, in a case where the ratio of the styrene-based monomer is increased in the optical resin, the ratio of the styrene-based monomer to the maleimide-based monomer needs to be sufficiently increased as a raw material monomer.

In the binary system, the mole ratio between the maleimide-based monomer and the styrene-based monomer in the optical resin is preferably 41:59 to 75:25, more preferably 45:55 to 70:30, more preferably 50:50 to 65:35, more preferably 50:50 to 60:40, and more preferably 50:50 to 55:45. When the mole ratio between the maleimide-based monomer and the styrene-based monomer is made to be within the above-described range, it is possible to facilitate the peak area ratio to be within the above-described range and to facilitate a decrease in the haze. The homopolymer of the styrene-based monomers and the alternative copolymer of the maleimide-based monomer and the styrene-based monomer have different refractive indexes, and it is thus possible to facilitate a decrease in the haze by increasing the ratio of the maleimide-based monomer as described above. In addition, the ratio of the maleimide-based monomer is not excessively increased as described above, whereby it is possible to suppress an article containing the optical resin becoming brittle and easily breaking.

The mole ratio between the maleimide-based monomer and the styrene-based monomer in the optical resin can be calculated by the measurement of a ¹³C-NMR spectrum.

In the optical resin of the present disclosure, a different monomer other than the maleimide-based monomer and the styrene-based monomer may also be used as a polymerizable monomer component to an extent that the effect of the present disclosure is not impaired. In other words, the optical resin of the present disclosure may contain a multicomponent copolymer of the maleimide-based monomer, the styrene-based monomer, and the different monomer to an extent that the effect of the present disclosure is not impaired. The multicomponent copolymer may be a ternary copolymer containing one kind of the different monomer or may be a quaternary or higher copolymer containing two or more kinds of the different monomers.

Examples of the different monomer include monomers having an ethylenic unsaturated bond group, such as a (meth)acryloyl group, a vinyl group, and an aryl group. Specific examples of the different monomer include ethylene, methyl acrylate, ethyl acrylate, methyl methacrylate, ethyl methacrylate, isobutene, and the like.

The mole ratio between "the maleimide-based monomer" and "the total of the styrene-based monomer and the different monomer" in the multicomponent copolymer is preferably 41:59 to 75:25, more preferably 45:55 to 70:30, more preferably 50:50 to 65:35, more preferably 50:50 to 60:40, and more preferably 50:50 to 55:45.

When a resin other than the alternative copolymer of the maleimide-based monomer and the styrene-based monomer is contained as the optical resin, the haze is likely to become high. On the other hand, the multicomponent copolymer is useful since it is difficult to increase the haze.

The optical resin of the present disclosure may also contain a resin other than the alternative copolymer of the maleimide-based monomer and the styrene-based monomer to an extent that the effect of the present disclosure is not impaired. Examples of the resin other than the alternative copolymer of the maleimide-based monomer and the styrene-based monomer include homopolymers of the maleimide-based monomers, homopolymers of the styrene-based monomers, ternary copolymers of the maleimide-based monomer, the styrene-based monomer, and the different monomer, and the like.

When the resin other than the alternative copolymer of the maleimide-based monomer and the styrene-based monomer is contained as the optical resin, the haze is likely to increase. Therefore, the mass ratio of the alternative copolymer of the maleimide-based monomer and the styrene-based monomer to the total amount of the optical resin of the present disclosure is preferably 40 mass% or more, more preferably 50 mass% or more, still more preferably 60 mass% or more, still more preferably 80 mass% or more, and still more preferably 90 mass% or more to make it easy to suppress the occurrence of birefringence due to stress.

Regarding the weight-average molecular weight of the alternative copolymer of the maleimide-based monomer and the styrene-based monomer, the lower limit is preferably 30,000 or more, more preferably 80,000 or more, and still more preferably 100,000 or more, and the upper limit is preferably 3,000,000 or less, more preferably 1,500,000 or less, still more preferably 800,000 or less, and still more preferably 600,000 or less. The weight-average molecular weight of the multicomponent copolymer of the maleimide-based monomer, the styrene-based monomer, and the different monomer is also preferably within the above-described range.

When the weight-average molecular weight is made to be 30,000 or more, it is possible to suppress an article containing the optical resin becoming brittle and easily breaking. When the weight-average molecular weight is made to be 3,000,000 or less, it is easy to dissolve the optical resin in a solvent and easy to suppress the melt viscosity of the optical resin becoming excessively high, which makes it possible to facilitate improvement in the workability of an article containing the optical resin. The weight-average molecular weight is preferably 600,000 or less to decrease the melt viscosity.

In the present specification, the weight-average molecular weight is an average molecular weight in terms of standard polystyrene that is measured by GPC analysis.

### <Physical properties>

In the optical resin of the present disclosure, in order to suppress the occurrence of birefringence due to stress, the absolute value of the photoelastic coefficient is preferably 6.0 × 10⁻¹² /Pa or less, more preferably 4.0 × 10⁻¹² /Pa or less, more preferably 3.0 × 10⁻¹² /Pa or less, more preferably 2.0 × 10⁻¹² /Pa or less, and more preferably 1.5 × 10⁻¹² /Pa or less.

In order to improve the heat resistance, the glass transition temperature of the optical resin of the present disclosure is preferably 100°C or higher and more preferably 120°C or higher. CPUs that are used in image display devices, such as personal computers and smartphones, are often designed at a peak temperature of near 100°C. Therefore, when the glass transition temperature is made to be 100°C or higher, it is possible to facilitate the application of the optical resin of the present disclosure to image display devices.

The glass transition temperature of the optical resin of the present disclosure is preferably 190°C or lower, more preferably 180°C or lower, and still more preferably 175°C or lower. When the glass transition temperature is made to be 190°C or lower, it is possible to decrease the temperature during molding, and it is thus possible to facilitate the thermal decomposition of the optical resin to be suppressed. In addition, when the glass transition temperature of the optical resin becomes high, the flex resistance is likely to deteriorate, and cracks are thus likely to be generated when an optical film is wound in a roll shape or a molded product is curved. In order to suppress cracks, the glass transition temperature is preferably 175°C or lower and more preferably 160°C or lower.

An increase in the glass transition temperature of the optical resin can be made to be easy by, for example, "increasing the ratio of the maleimide-based monomer", "using an alkyl group having a branch as the substituent of the N-substituted maleimide", or "decreasing the number of carbon atoms in the substituent of the N-substituted maleimide."

In the present specification, the glass transition temperature means a value that is measured as "midpoint glass transition temperature" in the differential scanning calorimetry of JIS K 7121: 1987.

The refractive index of the optical resin of the present disclosure at a wavelength of 589 nm is preferably 1.48 or more and 1.57 or less and more preferably 1.49 or more and 1.56 or less. When the refractive index is made to be 1.48 or more and 1.57 or less, the refractive index difference between the optical film of the present disclosure, which will be described below, and a functional layer can be easily decreased at the time of laminating the functional layer on the optical film, and it is thus possible to facilitate reflection in the interface between the optical film and the functional layer to be suppressed.

In a case where the optical resin is used in a lens, it is also preferable to make the refractive index to be above the above-described range. Specifically, in a case where the optical resin is used in a lens, the refractive index may be 1.48 or more and 1.80 or less. In a case where the optical resin is used in, among lenses, an AR lens or a VR lens, the refractive index is preferably 1.55 or more and 1.65 or less.

The refractive index of the optical resin is measured by a method described in Examples using a film that is made of the optical resin. In the case of a molded product molded from the optical resin, the refractive index is measured by the method described in Examples using a film that is formed from a solution containing the optical resin, which configures the molded product, dissolved in a solvent by a casting method. Here, in a case where the molded product has a flat plate shape, the refractive index may be measured by the method described in Examples from the molded product.

### [Optical film]

The optical film of the present disclosure contains the above-described optical resin of the present disclosure.

The optical film of the present disclosure is capable of suppressing the occurrence of birefringence due to stress since a resin component is made of the optical resin of the present disclosure.

The optical film of the present disclosure may contain an additive as a component other than the above-described optical resin of the present disclosure. Examples of the additive include an ultraviolet absorber, a light stabilizer, an antioxidant, an antiblocking agent, a refractive index modifier, and the like.

The thickness of the optical film is preferably 10 µm or more, more preferably 20 µm or more, and still more preferably 30 µm or more to improve the mechanical strength.

The thickness of the optical film is preferably 100 µm or less, more preferably 80 µm or less, and still more preferably 60 µm or less to improve the processing suitability.

In the present specification, the thickness of the optical film means the average value of the thicknesses of the optical film at 10 arbitrary sites. The thicknesses of the optical film at 10 arbitrary sites can be measured with a general-purpose film thickness meter.

The optical film can be produced by general-purpose film formation means, such as a casting method or an inflation method. The temperature at the time of forming the optical film is preferably set to the glass transition temperature or lower to improve the flatness of the optical film. On the other hand, when the temperature at the time of forming the optical film is too low, there are cases where a solvent remains and the physical properties of the optical film deteriorate. Therefore, the temperature at the time of forming the optical film is preferably 100°C or higher.

The optical film may be a film stretched by monoaxial stretching, biaxial stretching, or the like. That is, the optical film may be a stretched film. Stretched films are likely to shrink due to heat, but the optical film of the present disclosure is capable of suppressing the occurrence of birefringence even when stress is generated due to shrinkage.

The haze of JIS K 7136: 2000 of the optical film is preferably 2.0% or less, more preferably 1.0% or less, more preferably 0.7% or less, or more preferably 0.5% or less.

The total luminous transmittance of JIS K 7361-1: 1997 of the optical film is preferably 85% or more, more preferably 87% or more, and still more preferably 90% or more.

### <Size, shape, and the like>

The optical film and a polarizing plate, which will be described below, may have a single-leaf form cut into a predetermined size or may have a roll shape obtained by winding a long sheet in a roll form. The size of the single leaf is not particularly limited, but the maximum diameter is approximately two inches or more and 500 inches or less. "The maximum diameter" refers to the maximum length when two arbitrary points in the optical film connected together. For example, in a case where the optical film has a rectangular shape, the diagonal line of the rectangular shape becomes the maximum diameter. In a case where the optical film has a circular shape, the diameter of the circle becomes the maximum diameter.

The width and length of the roll shape are not particularly limited; however, usually, the width is 500 mm or more and 8000 mm or less, and the length is approximately 100 m or more and 10000 m or less. The roll-shaped optical film can be cut into a single-leaf shape according to the size of an image display device or the like and used. Upon cutting, it is preferable to exclude the roll edge portions where the physical properties are not stable.

The single-leaf shape is also not particularly limited and may be, for example, a polygonal shape such as a triangular shape, a square shape, or a pentagonal shape, a circular shape or a random undefined shape.

### [Polarizing plate]

A polarizing plate of the present disclosure is a polarizing plate having a polarizer, a first transparent protection plate arranged on one side of the polarizer, and a second transparent protection plate arranged on the other side of the polarizer, in which at least one selected from the group consisting of the first transparent protection plate and the second transparent protection plate includes the above-described optical film of the present disclosure.

### <Polarizer>

Examples of the polarizer include sheet-type polarizers such as a polyvinyl alcohol film, a polyvinyl formal film, a polyvinyl acetal film, and an ethylene-vinyl acetate copolymer-based saponified film that are dyed with iodine or the like and stretched, wire gridtype polarizers composed of a number of metal wires arrayed in parallel, coated polarizers coated with lyotropic liquid crystal or a dichroic guest-host material, multilayer thin film-type polarizers, and the like. These polarizers may be reflection-type polarizers having a function of reflecting a polarized component that the polarizers do not transmit.

In the present specification, "polarizer" refers to a material having a function of transmitting light in a predetermined vibration direction and not transmitting light in a vibration direction almost perpendicular to the vibration direction. Not transmitting light means that light is absorbed and/or reflected.

### <Transparent protection plates>

The first transparent protection plate is arranged on one side of the polarizer, and the second transparent protection plate is arranged on the other side. At least one selected from the group consisting of the first transparent protection plate and the second transparent protection plate includes the above-described optical film of the present disclosure.

In a case where transparent protection plates causing birefringence due to stress are used as the transparent protection plates for the polarizer, even when two polarizing plates are arranged in a crossed Nicol arrangement, it is not possible to block light, and there is a possibility of the occurrence of light leakage. The polarizing plate of the present disclosure includes the above-described optical film of the present disclosure as at least one selected from the group consisting of the first transparent protection plate and the second transparent protection plate and is thereby capable of suppressing light leakage.

In the polarizing plate of the present disclosure, it is preferable that both the first transparent protection plate and the second transparent protection plate include the above-described optical films of the present disclosure.

As a transparent protection plate that does not include the optical film of the present disclosure among the first transparent protection plate and the second transparent protection plate, a general-purpose plastic film, glass, or the like can be used.

The polarizer and the transparent protection plates are preferably pasted together with an adhesive. As the adhesive, a general-purpose adhesive can be used, and particularly, a PVA-based adhesive and an ultraviolet-curable adhesive are preferable.

The first transparent protection plate and/or the second transparent protection plate may be an optical laminate having a functional layer laminated on the optical film of the present disclosure.

### <Optical laminate>

The optical laminate has one or more functional layers on the above-described optical film of the present disclosure.

### <<Functional layer>>

The functional layer may have a single-layer configuration or a multilayer configuration. The functional layer may be formed on only one surface of the optical film or may be formed on both surfaces.

Examples of layers that configure the functional layer include an easy-adhesion layer, a phase difference layer, a hard coat layer, an antiglare layer, an antireflection layer, an antifouling layer, an antistatic layer, a specific wavelength absorption layer, a specific wavelength reflection layer, a decorative layer, an adhesive layer, and the like. The functional layer may be a single layer having a plurality of functions.

Among the functional layers, examples of the antireflection layer include a single-layer structure and a multilayer structure. Examples of a single-layer antireflection layer include a single low-refractive index layer. Examples of a multilayer antireflection layer include two layers of a high-refractive index layer and a low-refractive index layer and further include a configuration of three or more layers.

The configurations of the functional layers, such as the easy-adhesion layer, the phase difference layer, the hard coat layer, the antiglare layer, the antireflection layer, the antifouling layer, the antistatic layer, and the adhesive layer, can be general-purpose configurations.

Examples of the laminate configuration of the optical laminate include the following embodiments B1 to B15. In the following B1 to B15, "/" means an interface between layers. In addition, in the following laminate configurations B1 to B15, an embodiment having one or more easy-adhesion layers between layers is also included.

B1: Optical film/hard coat layer
B2: Optical film/antiglare layer
B3: Optical film/hard coat layer/antireflection layer
B4: Optical film/antiglare layer/antireflection layer
B5: Optical film/hard coat layer/antifouling layer
B6: Optical film/antiglare layer/antifouling layer
B7: Optical film/ phase difference layer
B8: Adhesive layer/optical film
B9: Adhesive layer/optical film/hard coat layer
B10: Adhesive layer/optical film/antiglare layer
B11: Adhesive layer/optical film/hard coat layer/antireflection layer
B12: Adhesive layer/optical film/antiglare layer/antireflection layer
B13: Adhesive layer/optical film/hard coat layer/ antifouling layer
B14: Adhesive layer/optical film/antiglare layer/antifouling layer
B15: Adhesive layer/optical film/ phase difference layer

### [Surface plate for image display device]

A surface plate for an image display device of the present disclosure is a surface plate for an image display device having a protective film pasted onto a resin plate or a glass plate, in which the protective film includes the above-described optical film of the present disclosure.

The protective film may have a functional layer formed on the optical film. That is, the protective film may be the above-described optical laminate.

As the resin plate or the glass plate, a resin plate or glass plate that is generally used as a surface plate in image display devices can be used.

The thickness of the resin plate or the glass plate is preferably 10 µm or more to improve the strength. The upper limit of the thickness of the resin plate or the glass plate is normally 5000 µm or less. For thickness reduction, the upper limit of the thickness of the resin plate or the glass plate is preferably 1000 µm or less, more preferably 500 µm or less, and still more preferably 100 µm or less.

### [Image display panel]

An image display panel of the present disclosure has the above-described optical film of the present disclosure on a display element.

The optical film may have a functional layer formed therein. That is, the image display panel of the present disclosure may have the above-described optical laminate on a display element.

Examples of the display element include liquid crystal display elements, EL display elements such as an organic EL display element and an inorganic EL display element, plasma display elements, and the like, and further include LED display elements such as a mini LED display element and a micro LED display element. These display elements may have a touch panel function in the display element.

Examples of the display mode of liquid crystals in the liquid crystal display elements include an IPS mode, a VA mode, a multidomain mode, an OCB mode, a STN mode, a TSTN mode, and the like. In a case where the display element is a liquid crystal display element, a backlight is required. Examples of the backlight include backlights in which a quantum dot is used and backlights in which a white light-emitting diode is used.

The image display panel may be a foldable image display panel or a rollable image display panel. In addition, the image display panel may be an image display panel with a touch panel.

### [Image display device]

An image display device of the present disclosure includes the above-described image display panel of the present disclosure.

The image display device of the present disclosure preferably further includes a driving control portion electrically connected to the image display panel and a chassis that accommodates the image display panel, the driving control portion, and the like.

### [Molded product for optics]

A molded product for optics of the present disclosure includes the above-described optical resin of the present disclosure.

The molded product for optics of the present disclosure may contain an additive as a component other than the above-described optical resin of the present disclosure. Examples of the additive include an ultraviolet absorber, a light stabilizer, an antioxidant, a refractive index modifier, and the like.

The molded product for optics of the present disclosure is capable of suppressing the occurrence of birefringence due to stress since a resin component is made of the optical resin of the present disclosure.

Examples of the molded product for optics include a lens, a light guide plate, a prism sheet, an image display member, a light-transmitting cover, and the like. These molded products for optics can be produced by, for example, general-purpose molding means, such as injection molding or extrusion molding.

Examples of the lens include AR lenses, VR lenses, MR lenses, convex lenses, concave lenses, meniscus lenses (concave-convex lenses), diffractive lenses, Fresnel lenses, lenticular lenses, toroidal lenses, ball lenses, aspherical lenses, and the like. The lens of the present disclosure is not limited to the above-listed kinds of lenses and can be applied to general-purpose lenses.

It is preferable that an antireflection layer is provided on the surface of the lens.

The haze of JIS K 7136: 2000 of the lens is preferably 2.0% or less. The total luminous transmittance of JIS K 7361-1: 1997 of the lens is preferably 85% or more.

The light guide plate is a member that is mainly used as an edge light-type surface light source. The shape of the light guide plate is, for example, a substantially flat plate-like shape in which at least one surface serves as a light incoming surface and one surface that is substantially orthogonal to the light incoming surface serves as a light outgoing surface. The light guide plate of the present disclosure is not limited to the above-described light guide plate in terms of use and shape and can be applied to general-purpose light guide plates.

The prism sheet is an optical member that changes the angle of light. The prism sheet is mainly used as a member for a surface light source. The shape of the prism sheet is, for example, a substantially flat plate-like shape in which a periodic structure is provided on a light outgoing surface. Examples of the periodic structure include a pyramid shape, a structure column having a triangular cross section, and the like. The prism sheet of the present disclosure is not limited to the above-listed prism sheets in terms of use and shape and can be applied to general-purpose prism sheets.

The image display member is a member for visually recognizing image light. Examples of the image display member include transparent screens, in-vehicle panels, in-vehicle pillars, and the like.

The light-transmitting cover is used as a cover member for protecting a device that injects light, such as LiDAR, or protecting an object through which a person visually recognizes something, such as a car instrument.

The present disclosure includes the following [1] to [13].
[1] An optical resin, wherein, regarding a ¹³C-NMR spectrum of the optical resin, when a range in which a chemical shift is 141 ppm or higher and 147 ppm or lower is defined as a first range, and a range in which a chemical shift is 135 ppm or higher and 141 ppm or lower is defined as a second range, a ratio of a peak area of a peak in the first range to a peak area of a peak in the second range is 0.55 or less.
[2] The optical resin according to [1], wherein the optical resin contains an alternative copolymer of a maleimide-based monomer and a styrene-based monomer.
[3] The optical resin according to [2], wherein one or more selected from the group consisting of a maleimide and a N-substituted maleimide substituted with a substituent having 1 or more and 6 or less carbon atoms are contained as the maleimide-based monomer.
[4] The optical resin according to [2], wherein one or more selected from the group consisting of styrene, α-methylstyrene, o-methylstyrene, m-methylstyrene, and p-methylstyrene are contained as the styrene-based monomer.
[5] The optical resin according to [2], wherein at least one or more monomers selected from the group consisting of the maleimide-based monomer and the styrene-based monomer contain a biomass-derived component.
[6] The optical resin according to any one of [1] to [5], wherein the optical resin has an absolute value of a photoelastic coefficient of 6.0 × 10⁻¹² /Pa or less.
[7] The optical resin according to any one of [1] to [6], wherein the optical resin has a glass transition temperature of 100°C or higher and 190°C or lower.
[8] An optical film, containing the optical resin according to any one of [1] to [7].
[9] The optical film according to [8], wherein the optical film has a haze of JIS K 7136: 2000 of 2.0% or less.
[10] A polarizing plate, having a polarizer; a first transparent protection plate arranged on one side of the polarizer; and a second transparent protection plate arranged on another side of the polarizer,
   wherein at least one selected from the group consisting of the first transparent protection plate and the second transparent protection plate includes the optical film according to [8] or [9].
[11] A surface plate for an image display device, having a protective film pasted onto a resin plate or a glass plate, wherein the protective film includes the optical film according to [8] or [9].
[12] An image display panel, having the optical film according to [8] or [9] on a display element.
[13] An image display device, including the image display panel according to [12].
[14] A molded product for optics, including the optical resin according to any one of [1] to [7].
[15] The molded product for optics according to [14], wherein the molded product is any selected from the group consisting of a lens, a light guide plate, a prism sheet, an image display member, and a light-transmitting cover.

### Examples

Hereinafter, an optical resin and an optical film of the present disclosure will be specifically described with Examples and Comparative Examples. The optical resin and the optical film of the present disclosure are not limited to forms to be described in Examples.

### 1. Evaluation and measurement

The following measurement and evaluation were performed on optical resins and optical films obtained in the Examples and the Comparative Examples. The measurement and evaluation were performed on sites free from defects such as a foreign matter, a scratch, and a wrinkle. The results are shown in Table 1. Unless particularly otherwise described, the following measurement and evaluation were performed in an atmosphere in which the temperature was 23°C ± 5°C and the relative humidity was 40% or higher and 65% or lower. In addition, unless particularly otherwise described, samples were exposed to the atmosphere for 30 minutes or longer and 60 minutes or shorter before each measurement.

### 1-1. Calculation of peak area ratio by measuring ¹³C-NMR spectrum

The ¹³C-NMR spectra of the optical resins of the Examples and the Comparative Examples were measured. Trade name "AVANCE III HD" manufactured by Bruker was used as a measuring instrument, and trade name "TopSpin 3.2" manufactured by Bruker was used as software. Measurement conditions were as described below. "Cumulative count: 10,000 times" in the measurement conditions means that a measurement result is the average value of 10,000 times of measurement. Based on the measurement results, the peak area ratios of the optical resin of the Examples and the Comparative Examples were calculated.

### <Measurement conditions>

Observation nuclear: 13C
Observation frequency: 100.65 MHz
Measurement temperature: Room temperature (23°C)
Measurement solvent: · DMSO-d6 (dimethylsulfoxide, deuteration rate: 99.9%)
Pulse program: zgig30 (quantitative measurement method)
Pulse width: 10.0 µsec
Waiting time: 15 seconds
Cumulative count: 10,000 times
Specimen concentration (specimen/measurement solvent): 100 mg/1.0 ml
Specimen solution amount: 0.75 ml
Specimen pipe: NMR sample tube (manufactured by Wilmad, product No. 535-PP-7)

### <Peak area ratio calculation procedure>

After the completion of the measurement, displayed spectra were converted into NMR spectra, and calibration was performed so that, among about seven peaks (peaks of DMSO-d6) shown at 38.8 ppm or higher and 40.2 ppm or lower, a peak showing the maximum value at near 39.5 ppm was positioned at 39.52 ppm. The integral values of a peak shown at 141 ppm or higher and 147 ppm or lower (a peak in a first range) and a peak shown at 135 ppm or higher and 141 ppm or lower (a peak in a second range) were obtained, and the peak area ratio was calculated. The peak area ratio is represented by the following equation. Peak area ratio = (integral value of peak in second range)/(integral value of peak in first range)

The integral value of each peak can be calculating by clicking a button "Pick Peaks" on the screen of the software and then selecting a ppm range from which the integral value needs to be calculated.

### 1-2. Photoelastic coefficient

Samples were made from the optical films of the Examples and the Comparative Examples, and the photoelastic coefficients of the optical resins were measured using the made samples. The shapes of the samples conformed to the following shape. Trade name "automatic birefringence controller ABR-EX" manufactured by Uniopt Co., Ltd. was used as a measuring instrument. The measurement conditions were as described below. Average values of three times of measurement were used as the photoelastic coefficients of the Examples and the Comparative Examples.

### <Measurement conditions>

Deformation mode: Tensile measurement
Measurement wavelength: 633 nm
Measurement speed: 0.1 mm/min
Tensile stress: 0 to 2 N (retardation is measured by applying stress at intervals of approximately 0.1 N)
Width of measurement portion: 4 to 5 mm
Calculation method: The photoelastic coefficient is calculated from the retardation and the width and film thickness of the measurement portion within a tensile stress range of 0.3 to 2 N.

### <Sample shape>

A sample with a shape of Fig. 1. l₁, l₂, l₃, r, b, b₁, b₂, and b₃ are as shown below. "r" in Fig. 1 is the radius of curvature.
l₁: 11.0 mm
l₂: 22.0 mm
l₃: 4.0 mm
r: 3.0 mm
b₁: 16.0 mm
b₂: 4.5 mm
b₃: 2.0 mm

### 1-3. Refractive index

Samples were made from the optical films of the Examples and the Comparative Examples, and the refractive indexes of the optical resins at a wavelength of 589 nm were measured using the made samples. The shapes of the samples were a 10 mm × 10 mm square shape. Trade name "PRISM COUPLER" manufactured by Metricon Corporation was used as a measuring instrument. Upon the measurement, the optical film was placed between the coupling bed, which is a specimen stand, of the measuring instrument and the prism of the measuring instrument. Upon the measurement, there was an air phase formed between the prism and the optical film. The refractive indexes were measured at five wavelengths of 404 nm, 594 nm, 656 nm, 786 nm, and 829 nm, and the refractive index at a wavelength of 589 nm was calculated using Cauchy's dispersion formula. Average values of five times of measurement were used as the refractive indexes of the Examples and the Comparative Examples.

### 1-4. Total luminous transmittance and haze

The total luminous transmittance of JIS K 7361-1: 1997 and the haze of JIS K 7136: 2000 of the optical films of the Examples and the Comparative Examples were measured using a haze meter (product No.: HM-150, Murakami Color Research Laboratory). The measurement was performed five times, and average values of the three times of measurement excluding the maximum value and the minimum value were used as the total luminous transmittance and haze of the Examples and the Comparative Examples.

### 1-5. Light leakage

A non-polarized surface emitting light table (product No. "400-TBL-006" manufactured by Sanwa Supply Inc., front brightness: 1500 cd/m²) was prepared. Two polarizing plates were arranged on the light table such that the absorption axes crossed each other. The arrangement is a so-called "crossed Nicol" arrangement. Furthermore, a 1 mm-thick optical plate made of each of the optical resins of the Examples and the Comparative Examples was placed between the two polarizing plates, thereby making a sample for light leakage evaluation. The size of the evaluation sample was set to 5 cm × 5 cm.

Whether or not light leakage occurred at the time of applying loads of 2 N or higher and 10 N or lower only to the optical plate in the evaluation sample was observed at a variety of angles in a dark room environment. The occurrence of light leakage was evaluated by 10 adults and rated according to the following standards. A direction in which the loads are applied to the optical plate was set to be in a direction at 45 degrees with respect to the absorption axis of the polarizing plate.

The light leakage is determined by a phase difference. Specifically, as the phase difference becomes larger, the degree of polarization of light in the crossed Nicol arrangement is changed more. "Phase difference = film thickness × photoelastic coefficient × stress." Therefore, when the same stress is applied to optical plates with the same film thickness, as the photoelastic coefficient becomes larger, the phase difference becomes larger, and light leakage is more likely to occur.
A: Eight or more persons answers that light leakage does not occur
B: Six or more and eight or less persons answers that light leakage does not occur
C: Five or less persons answers that light leakage does not occur

### 1-6. Flex resistance

Mandrel tests were performed on the optical films of the Examples and the Comparative Examples in accordance with the cylindrical mandrel of JIS K 5600-5-1: 1999, and the flex resistance was visually evaluated according to the following standards. A tester of JIS Type 1 was used as a tester. The testing environment and the sample drying conditions conformed to JIS arrangement.
AA: No cracks are generated even when the Mandrel diameter is 2 mm.
A: Cracks are generated when the Mandrel diameter is 2 mm, but no cracks are generated at a diameter of 3 mm.
B: Cracks are generated when the Mandrel diameter is 3 mm, but no cracks are generated at a diameter of 4 mm.
C: Cracks are generated when the Mandrel diameter is 4 mm, but no cracks are generated at a diameter of 5 mm.
D: Cracks generated when the Mandrel diameter is 5 mm.

### 1-7. Steel wool resistance

Steel wool tests were performed using the optical films of the Examples and the Comparative Examples, and the steel wool resistance was evaluated. Specifically, 50 mm × 100 mm-sized samples were cut out from the optical films of the Examples and the Comparative Examples. The sample was fixed onto a glass plate using CELLOTAPE (registered trademark) manufactured by Nichiban Co., Ltd. Steel wool (product name "BONSTAR #0000" manufactured by Nihon Steel Wool Co., Ltd.) was reciprocated in a state where the steel wool was brought into contact with the surface of the sample at a load of 50 g/cm². The motion speed of the steel wool was set to 50 mm/second. Each time the reciprocating motion was completed, the presence or absence of scratches on the surface of the optical film was visually confirmed and evaluated according to the following standards.
A: No scratches are generated even after five times of the reciprocation.
B: No scratches are generated after one time of the reciprocation, but scratches are generated after two to five times of the reciprocation.
C: Scratches are generated even after one time of the reciprocation.

### 1-8. Pencil hardness

Pencil hardness tests were performed on the optical films of the Examples and the Comparative Examples. The pencil hardness tests were performed under conditions to be described below with reference to Scratch hardness (Pencil method) of JIS K 5600-5-4: 1999 (the pencil hardness tests were performed with some of the conditions changed from JIS).

### <Conditions>

· Speed: 1 mm/s
· Distance: 7 mm
· Temperature: 23°C ± 2°C
· Relative humidity: 50 ± 5%
· Angle of pencil: 45 degrees
· Direction of test (direction of scratch with pencil): A direction in which the angle formed between the sample and the pencil is acute. In the JIS regulation, the test is performed in a 135° direction in which the angle formed between the sample and the pencil is obtuse; however, in the present measurement, the test was performed in a 45° direction in which the angle was acute.
· Load: 500 g

### 1-9. Comprehensive evaluation of scratch resistance

Optical films for which the steel wool resistance was evaluated as B or higher in 1-7 and the pencil hardness was 3B or higher in 1-8 were regarded as "pass."
Optical films for which the steel wool resistance was evaluated as C or lower in 1-7 and/or the pencil hardness was 4B or lower in 1-8 were regarded as "fail."

### 1-10. Glass transition temperature

The glass transition temperatures of the optical resins of the Examples and the Comparative Examples were measured. Product No. "DSC-60" manufactured by Shimadzu Corporation was used as a measuring instrument. The measurement conditions were as described below.

### <Measurement conditions>

Specimen amount: 10.0 mg
Specimen container: Aluminum pan
Temperature condition: The temperature was raised from room temperature to 220°C at 10 °C/min. The temperature was held at 220°C for three minutes. The temperature was lowered from 220°C to 20°C at -10 °C/min. The temperature was held at 20°C for three minutes. The temperature was raised from 20°C to 220°C at 10 °C/min. The temperature was held at 220°C for three minutes. The temperature was lowered from 220°C to 20°C at - 10 °C/min.
Calculation of glass transition temperature: The midpoint of a value obtained by reading the dislocation temperature from a DSC curve at the time of the second heating was regarded as the glass transition temperature. That is, the midpoint glass transition temperature in (1) of 9.3 of JIS K 7121: 1987 was regarded as the glass transition temperatures of the optical resins of the Examples and the Comparative Examples.

### 2. Making of optical resins and optical films

### [Example 1]

The inside of a 500 ml separable flask was substituted with nitrogen. 37.5 g of cyclohexanone and 25.0 g of N-ethylmaleimide were put into the separable flask and stirred with a stirring blade to produce a solution. Furthermore, a solution obtained by dissolving 7.6 g of styrene and 0.03 g of a polymerization initiator (NOF Corporation, trade name: PERBUTYL O) in 3.8 g of cyclohexanone was put into the separable flask. The separable flask was heated at 70°C in an oil bath for eight hours. The separable flask was cooled to room temperature, 367 g of methyl ethyl ketone was then put into the separable flask and then moved to a 5 L flask. 2-Isopropanol was slowly added to the flask, and a turbid solution was obtained. One kilogram of 2-isopropanol was added to the turbid solution at once, thereby obtaining a white slurry. The white slurry was filtered. A washing and filtering operation to the filtered slurry with 2-isopropanol were repeated five times to obtain a powder. The collected powder was dried at 110°C under reduced pressure for six hours, thereby obtaining a polymer 1 (optical resin of Example 1).

One gram of the polymer 1 was dissolved in 8.0 g of methyl ethyl ketone to obtain a coating liquid. The coating liquid was applied using an applicator onto a polyethylene terephthalate film (COSMOSHINE A4160 manufactured by Toyobo Co., Ltd.) by a casting method. The film was put into a 100°C oven for five minutes, put into a 130°C oven for three minutes, and removed, thereby obtaining a coated film in which the coating liquid had been dried. The coated film was peeled off from the polyethylene terephthalate film, thereby obtaining an optical film (film thickness: 20 µm) of Example 1.

### [Example 2]

A polymer 2 (optical resin of Example 2) was obtained in the same manner as in Example 1 except that the amount of the N-ethylmaleimide was changed from 25.0 g to 2.5 g, the amount of the styrene was changed from 7.6 g to 8.3 g, and the amount of the polymerization initiator was changed from 0.03 g to 0.01 g.

One gram of the polymer 2 was dissolved in 6.0 g of methyl ethyl ketone to obtain a coating liquid. The coating liquid was applied using an applicator onto a polyethylene terephthalate film (COSMOSHINE A4160 manufactured by Toyobo Co., Ltd.) by a casting method. The film was put into a 100°C oven for five minutes, put into a 130°C oven for three minutes, and removed, thereby obtaining a coated film in which the coating liquid had been dried. The coated film was peeled off from the polyethylene terephthalate film, thereby obtaining an optical film (film thickness: 39 µm) of Example 2.

### [Comparative Example 1]

The inside of a 500 ml separable flask was substituted with nitrogen. 21.0 g of cyclohexanone and 1.0 g of a maleimide were put into the separable flask and stirred with a stirring blade to produce a solution. Furthermore, a solution obtained by dissolving 9.7 g of styrene and 0.02 g of a polymerization initiator (NOF Corporation, trade name: PERBUTYL O) in 6.0 g of cyclohexanone was put into the separable flask. The separable flask was heated at 70°C in an oil bath for eight hours. The separable flask was cooled to room temperature, 200 g of tetrahydrofuran was then put into the separable flask and then moved to a 5 L flask. 2-Isopropanol was slowly added to the flask, and a turbid solution was obtained. One kilogram of 2-isopropanol was added to the turbid solution at once, thereby obtaining a white slurry. The white slurry was filtered. A washing and filtering operation to the filtered slurry with 2-isopropanol were repeated five times to obtain a powder. The collected powder was dried at 110°C under reduced pressure for six hours, thereby obtaining a polymer 3 (optical resin of Comparative Example 1).

One gram of the polymer 3 was dissolved in 4.0 g of tetrahydrofuran to obtain a coating liquid. The coating liquid was applied using an applicator onto a polyethylene terephthalate film (COSMOSHINE A4160 manufactured by Toyobo Co., Ltd.) by a casting method. The film was put into a 70°C oven for five minutes, put into a 130°C oven for five minutes, and removed, thereby obtaining a coated film in which the coating liquid had been dried. The coated film was peeled off from the polyethylene terephthalate film, thereby obtaining an optical film (film thickness: 40 µm) of Comparative Example 1.

### [Example 3]

The inside of a 500 ml separable flask was substituted with nitrogen. 250.0 g of toluene and 20.0 g of a biomass-derived maleic anhydride were put into the separable flask and stirred with a stirring blade to produce a solution. Furthermore, 21.2 g of styrene and 0.20 g of a polymerization initiator (azobisisobutyronitrile) were put into the separable flask.

The separable flask was heated at 60°C in an oil bath for two hours, and a slurry in which a polymer had been precipitated was obtained. The slurry was cooled to room temperature, 150 g of toluene was then put into the separable flask, and furthermore, the slurry was filtered. A washing and filtering operation to the filtered slurry with toluene were repeated five times to obtain a powder. The collected powder was dried at 110°C under reduced pressure for six hours, thereby obtaining a polymer 4'.

The inside of a 500 ml separable flask was substituted with nitrogen. 50.0 g of N-methylpyrrolidine and 5.0 g of the polymer 4' were put into the separable flask and stirred with a stirring spring to produce a solution. 7.2 g of butylamine was added dropwise to the separable flask over 45 minutes. The separable flask was heated at 180°C in an oil bath for two hours and then cooled to room temperature, subsequently, 300 g of methyl ethyl ketone was put into the separable flask and stirred, thereby producing a solution. The solution was moved to a 5 L flask, 2-isopropanol was then slowly added thereto, and a turbid solution was obtained. One kilogram of 2-isopropanol was added to the turbid solution at once, thereby obtaining a white slurry. The slurry was filtered. A washing and filtering operation to the filtered slurry with 2-isopropanol were repeated five times to obtain a powder. The collected powder was dried at 110°C under reduced pressure for six hours, thereby obtaining a polymer 4 (optical resin of Example 3).

One gram of the polymer 4 was dissolved in 8.0 g of methyl ethyl ketone to obtain a coating liquid. The coating liquid was applied using an applicator onto a polyethylene terephthalate film (COSMOSHINE A4160 manufactured by Toyobo Co., Ltd.) by a casting method. The film was put into a 100°C oven for five minutes, then put into a 130°C oven for three minutes, and removed, thereby obtaining a coated film in which the coating liquid had been dried. The coated film was peeled off from the polyethylene terephthalate film, thereby obtaining an optical film (film thickness: 33 µm) of Example 3.

### [Example 4]

A polymer 5 (optical resin of Example 4) and an optical film of Example 4 were obtained in the same manner as in Example 3 except that 20.0 g of the biomass-derived maleic anhydride was changed to 20.0 g of a non-biomass-derived maleic anhydride.

### [Comparative Example 2]

The inside of a 500 ml separable flask was substituted with nitrogen. A solution obtained by dissolving 250.0 g of toluene, 40.0 g of styrene, and 0.20 g of a polymerization initiator (azobisisobutyronitrile) was put into the separable flask. The separable flask was heated at 60°C in an oil bath for eight hours, and a slurry in which a polymer had been precipitated was obtained. The slurry was cooled to room temperature, 150 g of toluene was then put into the separable flask, and furthermore, the slurry was filtered. A washing and filtering operation to the filtered slurry with toluene were repeated five times to obtain a powder. The collected powder was dried at 110°C under reduced pressure for six hours, thereby obtaining a polymer 6 (optical resin of Comparative Example 6).

One gram of the polymer 6 was dissolved in 5.0 g of methyl ethyl ketone to obtain a coating liquid. The coating liquid was applied using an applicator onto a polyethylene terephthalate film (COSMOSHINE A4160 manufactured by Toyobo Co., Ltd.) by a casting method. The film was put into a 100°C oven for five minutes, then put into a 130°C oven for three minutes, and removed, thereby obtaining a coated film in which the coating liquid had been dried. The coated film was peeled off from the polyethylene terephthalate film, thereby obtaining an optical film (film thickness: 20 µm) of Comparative Example 2.

### [Example 5]

A polymer 7 (optical resin of Example 5) was obtained in the same manner as in Example 1 except that the amount of the N-ethylmaleimide was changed from 25.0 g to 1.5 g, the amount of the styrene was changed from 7.6 g to 7.5 g, and the amount of the polymerization initiator was changed from 0.03 g to 0.02 g.

Next, an optical film of Example 5 was obtained in the same manner as in Example 2 except that the polymer 2 was changed to the polymer 7.

### [Comparative Example 3]

A polymer 8 (optical resin of Comparative Example 3) was obtained in the same manner as in Example 1 except that the amount of the N-ethylmaleimide was changed from 25.0 g to 1.0 g, the amount of the styrene was changed from 7.6 g to 7.5 g, and the amount of the polymerization initiator was changed from 0.03 g to 0.02 g.

Next, an optical film of Comparative Example 3 was obtained in the same manner as in Example 2 except that the polymer 2 was changed to the polymer 8.

### [Example 6]

A polymer 9 (optical resin of Example 6) was obtained in the same manner as in Example 1 except that 25.0 g of the N-ethylmaleimide was changed to 10.0 g of N-methylmaleimide, the amount of the styrene was changed from 7.6 g to 9.4 g, and the amount of the polymerization initiator was changed from 0.03 g to 0.3 g.

Next, an optical film of Example 6 was obtained in the same manner as in Example 2 except that the polymer 2 was changed to the polymer 9.

### [Example 7]

The inside of a 500 ml separable flask was substituted with nitrogen. 250.0 g of toluene and 20.0 g of a maleic anhydride were put into the separable flask and stirred with a stirring blade to produce a solution. Furthermore, 21.2 g of styrene and 0.20 g of a polymerization initiator (azobisisobutyronitrile) were put into the separable flask.

The separable flask was heated at 60°C in an oil bath for two hours, and a slurry in which a polymer had been precipitated was obtained. The slurry was cooled to room temperature, 150 g of toluene was then put into the separable flask, and furthermore, the slurry was filtered. A washing and filtering operation to the filtered slurry with toluene were repeated five times to obtain a powder. The collected powder was dried at 110°C under reduced pressure for six hours, thereby obtaining a polymer 10'.

The inside of a 500 ml separable flask was substituted with nitrogen. 40.0 g of N-methylpyrrolidine and 10.0 g of the polymer 10' were put into the separable flask and stirred with a stirring spring to produce a solution. 5.9 g of propylamine was added dropwise to the separable flask over 45 minutes. The separable flask was heated at 80°C in an oil bath for one hour, heated at 200°C for one hour and then cooled to room temperature, subsequently, 100 g of methyl ethyl ketone was put into the separable flask and stirred, thereby producing a solution. The solution was moved to a 5 L flask, 2-isopropanol was then slowly added thereto, and a turbid solution was obtained. One kilogram of 2-isopropanol was added to the turbid solution at once, thereby obtaining a white slurry. The slurry was filtered. A washing and filtering operation to the filtered slurry with 2-isopropanol were repeated five times to obtain a powder. The collected powder was dried at 110°C under reduced pressure for six hours, thereby obtaining a polymer 10 (optical resin of Example 7).

Three grams of the polymer 10 was dissolved in 13.0 g of 1,3-dioxolane to obtain a coating liquid. The coating liquid was applied using an applicator onto a polyethylene terephthalate film (COSMOSHINE A4160 manufactured by Toyobo Co., Ltd.) by a casting method. The film was put into a 100°C oven for five minutes, then put into a 130°C oven for three minutes, and removed, thereby obtaining a coated film in which the coating liquid had been dried. The coated film was peeled off from the polyethylene terephthalate film, thereby obtaining an optical film (film thickness: 37 µm) of Example 7.

### [Example 8]

A polymer 11 (optical resin of Example 8) was obtained in the same manner as in Example 7 except that the propylamine was changed to isopropylamine.

Next, an optical film of Example 8 was obtained in the same manner as in Example 7 except that the polymer 10 was changed to the polymer 11.

### [Example 9]

A polymer 12 (optical resin of Example 9) was obtained in the same manner as in Example 7 except that 5.9 g of the propylamine was changed to 7.2 g of isobutylamine.

Next, an optical film of Example 9 was obtained in the same manner as in Example 7 except that the polymer 10 was changed to the polymer 12.

### [Example 10]

A polymer 13 (optical resin of Example 10) was obtained in the same manner as in Example 7 except that 5.9 g of the propylamine was changed to 8.6 g of isopentylamine.

Next, an optical film of Example 10 was obtained in the same manner as in Example 7 except that the polymer 10 was changed to the polymer 13.

### [Comparative Example 4]

472 g of isopropyl acetate, 100 g of a maleic anhydride, and 0.14 g of a polymerization initiator (PERBUTYL O) were put into in a 2 L autoclave (material: SUS316, manufactured by Nitto Kouatsu) and sealed, and nitrogen was poured thereinto. 57 g of isobutene was pressed into the autoclave and stirred. The autoclave was heated at 70°C for 10 hours, and a slurry in which a polymer had been precipitated was obtained. The slurry was cooled to room temperature, 500 ml of isopropyl acetate was then put into the autoclave, and furthermore, the slurry was filtered. A washing and filtering operation to the filtered slurry with isopropyl acetate were repeated five times to obtain a powder. The collected powder was dried at 110°C under reduced pressure for 20 hours, thereby obtaining a polymer 14'.

The inside of a 500 ml separable flask was substituted with nitrogen. 40.0 g of N-methylpyrrolidine and 10.0 g of the polymer 14' were put into the separable flask and stirred with a stirring spring to produce a solution. 7.7 g of propylamine was added dropwise to the separable flask over 45 minutes. The separable flask was heated at 80°C in an oil bath for one hour, heated at 200°C for one hour and then cooled to room temperature, subsequently, 100 g of methyl ethyl ketone was put into the separable flask and stirred, thereby producing a solution. The solution was moved to a 5 L flask, 2-isopropanol was then slowly added thereto, and a turbid solution was obtained. One kilogram of 2-isopropanol was added to the turbid solution at once, thereby obtaining a white slurry. The slurry was filtered. A washing and filtering operation to the filtered slurry with 2-isopropanol were repeated five times to obtain a powder. The collected powder was dried at 110°C under reduced pressure for six hours, thereby obtaining a polymer 14 (optical resin of Comparative Example 4).

Three grams of the polymer 14 was dissolved in 15.0 g of 1,3-dioxolane to obtain a coating liquid. The coating liquid was applied using an applicator onto a polyethylene terephthalate film (COSMOSHINE A4160 manufactured by Toyobo Co., Ltd.) by a casting method. The film was put into a 100°C oven for five minutes, then put into a 130°C oven for three minutes, and removed, thereby obtaining a coated film in which the coating liquid had been dried. The coated film was peeled off from the polyethylene terephthalate film, thereby obtaining an optical film (film thickness: 34 µm) of Comparative Example 4.

### [Comparative Example 5]

A polymer 15 (optical resin of Comparative Example 5) was obtained in the same manner as in Comparative Example 4 except that 7.7 g of the propylamine was changed to 9.5 g of isobutylamine.

Next, an optical film of Comparative Example 5 was obtained in the same manner as in Comparative Example 4 except that the polymer 14 was changed to the polymer 15.

### [Comparative Example 6]

Ten grams of N-methylmaleimide and 0.01 g of PERBUTYL O as a polymerization initiator were charged into a glass sealed tube, and the glass sealed tube was substituted with nitrogen and then heated at 70°C in an oil bath for 24 hours. After the heating, the glass sealed tube was cooled to room temperature, 100 g of methyl ethyl ketone was added thereto and stirred, thereby producing a solution. The solution was moved to a 5 L flask, and 2-isopropanol was then slowly added thereto, and a turbid solution was obtained. One kilogram of 2-isopropanol was added to the turbid solution at once, thereby obtaining a white slurry. The slurry was filtered. A washing and filtering operation to the filtered slurry with 2-isopropanol were repeated five times to obtain a powder. The collected powder was dried at 110°C under reduced pressure for six hours, thereby obtaining a polymer 16 (optical resin of Comparative Example 6).

Next, an optical film of Comparative Example 6 was obtained in the same manner as in Comparative Example 4 except that the polymer 14 was changed to the polymer 16.

### [Comparative Example 7]

A polymer 17 (optical resin of Comparative Example 7) was obtained in the same manner as in Comparative Example 6 except that N-methylmaleimide was changed to N-ethylmaleimide.

Next, an optical film of Comparative Example 7 was obtained in the same manner as in Comparative Example 4 except that the polymer 14 was changed to the polymer 17.

### [Comparative Example 8]

A polymer 18 (optical resin of Comparative Example 8) was obtained in the same manner as in Comparative Example 6 except that N-methylmaleimide was changed to N-propylmaleimide.

Next, an optical film of Comparative Example 8 was obtained in the same manner as in Comparative Example 4 except that the polymer 14 was changed to the polymer 18.

### [Table 1]

**Table 1**

| | | Example 1 | Example 2 | Comparative Example 1 | Example 3 | Example 4 | Comparative Example 2 |
|---|---|---|---|---|---|---|---|
| Structure of alternative copolymer of maleimide-based monomer and styrene-based monomer | | | | 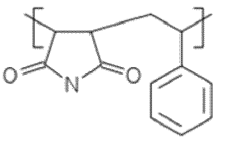 | | | No alternative copolymers are present since Comparative Example 2 is the homopolymer of the styrene-based monomers |
| Kind of maleimid e-based monomer | | N-ethylmaleimide | | Maleimide | N-butylmaleimide | | N/A |
| Kind of styrene-based monomer | | Styrene | | Styrene | Styrene | | Styrene |
| Different monomer | | N/A | | | | | |
| Mole ratio between maleimide-based monomer and styrene-based monomer in optical resin | | 65/35 | 47/53 | 36/64 | 50/50 | 50/50 | 0/100 |
| Presence or absence of second peak | | Present | Present | Present | Present | Present | Absent |
| Refractive index | | 1.55 | 1.55 | 1.58 | 1.56 | 1.56 | 1.59 |
| Total luminous transmittance (%) | | 91.2 | 91.1 | 90.2 | 91 | 91 | 90.2 |
| *Haze* (%) | | 0.5 | 0.3 | 2.4 | 0.3 | 0.3 | 0.4 |
| Photoelastic coefficient (×10⁻¹²/Pa) | | 1.0 | -1.1 | 6.3 | 2.6 | 2.6 | 8.9 |
| Peak area ratio | | 0 | 0.139 | 0.806 | 0 | 0 | ∞ |
| Light leakage | | A | A | B | A | A | C |
| Glass transition temperature (°C) | | 190 | 171 | - | 153 | *153* | 100 |
| Flex resistance | | C | A | A | AA | AA | AA |
| Scratch resistance | Steel wool resistance | A | A | B | A | A | C |
| | Pencil hardness | B | **2B** | 4B | 2B | **2B** | B |
| | Comprehensive evaluation of scratch resistance | Pass | Pass | Fail | Pass | Pass | Fail |

### [Table 2]

**Table 2**

| | | Example 5 | Comparative Example 3 | Example 6 | Example 7 | Example 8 | Example 9 | Example 10 | Comparative Example 4 | Comparative Example 5 | Comparative Example 6 | Comparative Example 7 | Comparative Example 8 |
|---|---|---|---|---|---|---|---|---|---|---|---|---|---|
| Kind of maleimide-based monomer | | N-ethylmaleimide | | N-methyl maleimide | N-propyl maleimide | N-isopropyl maleimide | N-isobutyl maleimide | N-isopentyl maleimide | N-propyl maleimide | N-isobutyl maleimide | N-methyl maleimide | N-ethyl maleimide | N-propyl maleimide |
| Kind of styrene-based monomer | | Styrene | | Styrene | Styrene | Styrene | Styrene | Styrene | N/A | | | | |
| Different monomer | | N/A | | | | | | | Isobutene | | N/A | | |
| Mole ratio between maleimide-based monomer and styrene-based monomer in optical resin | | 42/58 | 40/60 | 52/48 | 50/50 | 50/50 | 50/50 | 50/50 | 100/0 | | | | |
| Mole ratio between maleimide-based monomer and different monomer in optical resin | | 100/0 | | | | | | | 50/50 | 50/50 | 100/0 | | |
| Presence or absence of second peak | | Present | Present | Present | Present | Present | Present | Present | Absent | Absent | Absent | Absent | Absent |
| Refractive index | | 1.56 | 1.56 | 1.56 | 1.55 | 1.55 | 1.54 | 1.54 | 1.52 | 1.52 | 1.55 | 1.53 | 1.52 |
| Total luminous transmittance (%) | | 90.7 | 90.43 | 90.6 | 91 | 91 | 91.1 | 92 | 91.9 | 91.7 | - | - | - |
| Haze (%) | | 1.9 | 3.4 | 0.4 | 0.2 | 0.4 | 0.4 | 0.5 | 0.2 | 0.5 | - | - | - |
| Photoelastic coefficient (×10²/Pa) | | -0,3 | 0.0 | 0.6 | 0.2 | 2.8 | -2,0 | 0.6 | 6.5 | 6.8 | 11.9 | 7.1 | 9.5 |
| Peak area ratio | | 0.438 | 0.565 | 0 | 0 | 0 | 0 | 0 | - | - | - | - | - |
| Light leakage | | A | A | A | A | A | A | A | B | B | c | c | C |
| Glass transition temperature (°C) | | 163 | 159 | 192 | 157 | 168 | 153 | 139 | 97 | 92 | - | - | - |
| Flex resistance | | A | A | B | AA | A | AA | AA | AA | AA | D | D | D |
| Scratch resistance | Steel wool resistance | B | B | A | A | A | A | B | C | C | - | - | - |
| | Pencil hardness | 3B | 4B | B | 2B | 2B | 2B | 2B | 6B | 6B | - | - | - |
| | Comprehensive evaluation of scratch resistance | Pass | Fail | Pass | Pass | Pass | Pass | Pass | Fail | Fail | - | - | - |

From the results in Tables 1 and 2, it is possible to confirm that the optical resins and the optical films of the Examples are capable of suppressing the occurrence of birefringence due to stress and are thus capable of suppressing light leakage. In addition, from the comparison between Example 3 where the biomass-derived maleic anhydride was used and Example 4 where the non-biomass-derived maleic anhydride was used, it is possible to confirm that the optical resin and the optical film of the present disclosure are capable of suppressing the occurrence of birefringence due to stress even when a biomass-derived material is used and are thus capable of suppressing light leakage.

In addition, from the results in Tables 1 and 2, it is possible to confirm that the optical resins and the optical films of the Examples are capable of improving scratch resistance.

In addition, from the results in Tables 1 and 2, it is possible to confirm that the optical films of Examples 2 to 10 where the glass transition temperatures were lowered are capable of improving flex resistance.

## Claims

1. An optical resin, wherein, regarding a ¹³C-NMR spectrum of the optical resin, when a range in which a chemical shift is 141 ppm or higher and 147 ppm or lower is defined as a first range, and a range in which a chemical shift is 135 ppm or higher and 141 ppm or lower is defined as a second range, a ratio of a peak area of a peak in the first range to a peak area of a peak in the second range is 0.55 or less.

2. The optical resin according to Claim 1, wherein the optical resin comprises an alternative copolymer of a maleimide-based monomer and a styrene-based monomer.

3. The optical resin according to Claim 2, wherein one or more selected from the group consisting of a maleimide and a N-substituted maleimide substituted with a substituent having 1 or more and 6 or less carbon atoms are contained as the maleimide-based monomer.

4. The optical resin according to Claim 2, wherein one or more selected from the group consisting of styrene, α-methylstyrene, o-methylstyrene, m-methylstyrene, and p-methylstyrene are contained as the styrene-based monomer.

5. The optical resin according to Claim 2, wherein at least one or more monomers selected from the group consisting of the maleimide-based monomer and the styrene-based monomer comprise a biomass-derived component.

6. The optical resin according to Claim 1 or 2, wherein the optical resin has an absolute value of a photoelastic coefficient of 6.0 × 10⁻¹² /Pa or less.

7. The optical resin according to Claim 1 or 2, wherein the optical resin has a glass transition temperature of 100°C or higher and 190°C or lower.

8. An optical film, comprising:
the optical resin according to Claim 1 or 2.

9. The optical film according to Claim 8, wherein the optical film has a haze of JIS K 7136: 2000 of 2.0% or less.

10. A polarizing plate, comprising:
a polarizer;
a first transparent protection plate arranged on one side of the polarizer; and
a second transparent protection plate arranged on another side of the polarizer,
wherein at least one selected from the group consisting of the first transparent protection plate and the second transparent protection plate includes the optical film according to Claim 8.

11. A surface plate for an image display device, comprising:
a protective film pasted onto a resin plate or a glass plate,
wherein the protective film includes the optical film according to Claim 8.

12. An image display panel, comprising:
the optical film according to Claim 7 on a display element.

13. An image display device, comprising:
the image display panel according to Claim 12.

14. A molded product for optics, comprising:
the optical resin according to Claim 1 or 2.

15. The molded product for optics according to Claim 14, wherein the molded product is any selected from the group consisting of a lens, a light guide plate, a prism sheet, an image display member, and a light-transmitting cover.
